# EUROPEAN PATENT APPLICATION

(11) **EP 4 819 417 A2**
(43) Date of publication of application: **07.10.2026**
(21) Application number: 26161995.1
(22) Date of filing: 03.03.2026
(51) Int. Cl.: H01S 3/109, H01S 3/02, H01S 3/06, H01S 3/08, H01S 3/16, H01S 3/0941

(54) **SINGLE LONGITUDINAL MODE LASER WITH CURVED GAIN CRYSTAL**

(30) Priority: 31.03.2025 US 202519095667
(71) Applicant: Vector Atomic, Inc., Pleasanton, CA 94566 (US)
(72) Inventor: MOORE, Sean William, Maryland, 20740 (US); BOYD, Martin Machai, Maryland, 20740 (US); CINGOZ, Arman, Maryland, 20740 (US); OELKER, Eric Glenn, Massachusetts, 02472 (US); ROSLUND, Jonathan David, Maryland, 20740 (US)
(74) Representative: Kehl, Ascherl, Liebhoff & Ettmayr Patentanwälte Partnerschaft mbB

(57) **Abstract**

Embodiments herein describe a laser system that includes a gain crystal with a curved surface (e.g., a convex surface). That is, while gain crystals are often used to form diode pump lasers, these crystals typically are AR-coated flat-flat crystal with a separate concave HR mirror or a broadband concave output coupler (OC) to form a stable laser. However, forming a curved (e.g., convex) surface on the gain crystal enables stable operation of the laser without the need for a separate bulk optical component (e.g., a HR mirror or an OC).

## Description

### BACKGROUND

### Field

Embodiments of the present invention generally relate to optically pumped lasers with gain crystals.

### Description of the Related Art

Diode or laser pumped solid state lasers are often used to form compact, high power laser systems. These systems can be used for many applications such as laser machining, laser welding, as well as laser pointers. Moreover, solid state lasers that operate in single-longitudinal mode have found applications in optical interferometers, wavelength references as well as frequency comb stabilization, high precision atomic clocks, and the like.

These solid-state lasers typically include a gain crystal that amplifies light through stimulated emission. The gain crystal includes a host crystal or glass matrix doped with rare earth or transition metal ions. Gain crystals perform at least two of functions required for laser operation. First, they absorb pump energy. Second, they maintain a population inversion for stimulated emission. In some cases, the gain crystal may also function as part of the resonant cavity.

To perform stimulated emission, gain crystals are optically pumped where the dopants in the crystal absorb the pump light energy which excites them to higher energy levels. When these excited ions return to their ground state, they emit photons. This stimulated emission process is amplified within the laser cavity, resulting in the generation of coherent laser light. The specific characteristics of the laser such as its wavelength and energy conversion efficiency can be controlled based on the type of dopant and the host crystal.

Most common single longitudinal mode solid state lasers are based on nonplanar ring oscillators that consist of a neodymium yttrium aluminum garnet Nd:YAG crystal with multiple complex polishing surfaces as well as a magnet that enforces unidirectional lasing in a ring laser cavity. The traveling wave nature of the circulating light inhibits formation of a standing wave pattern inside the cavity that would cause spatial hole burning, which is deleterious for single-mode operation. These lasers are typically pumped with 808 nm pump lasers with limited lifetimes.

### SUMMARY

One embodiment described herein is a laser system that includes a pump laser configured to output a pump optical signal, a gain crystal including a curved surface to serve as one end mirror of a laser cavity where the gain crystal is configured to perform stimulated emission upon receiving the pump optical signal, and a narrowband reflective OC for the pump optical signal.

One embodiment described herein is a laser system that includes a pump focuser configured to output a pump optical signal, a gain crystal including a curved surface where the gain crystal is configured to perform stimulated emission upon receiving the pump optical signal, and narrowband reflective output coupler (OC) for the pump optical signal.

One embodiment described herein is a method of assembling a laser system. The method includes aligning a gain crystal with a curved surface to a narrowband reflective OC and aligning, after aligning the gain crystal to the narrowband reflective OC, a pump laser to the gain crystal and the narrowband reflective OC.

### BRIEF DESCRIPTION OF THE DRAWINGS

So that the manner in which the above recited features of the present disclosure can be understood in detail, a more particular description of the disclosure, briefly summarized above, may be had by reference to embodiments, some of which are illustrated in the appended drawings. It is to be noted, however, that the appended drawings illustrate only exemplary embodiments and are therefore not to be considered limiting of its scope, may admit to other equally effective embodiments.
Figure 1 illustrates a laser system with a diode pump laser, according to one embodiment.
Figure 2 illustrates a perspective view of a laser system with a diode pump laser, according to one embodiment.
Figure 3 is a flowchart for assembling a laser system, according to one embodiment.
Figures 4-8 illustrates various implementations of a laser system with a diode pump laser, according to several embodiments.

To facilitate understanding, identical reference numerals have been used, where possible, to designate identical elements that are common to the figures. It is contemplated that elements and features of one embodiment may be beneficially incorporated in other embodiments without further recitation.

### DETAILED DESCRIPTION

Embodiments herein describe a single longitudinal mode diode pump laser system that is based on a compact linear cavity configuration that is easy to manufacture and assemble. Furthermore, in one embodiment, the laser system utilizes a commercial, telecommunications- grade 980 nm pump laser that is robust with mean time between failures exceeding 100,000 hours. In one embodiment, in order to utilize 980-nm pumping, the gain crystal for the laser utilizes an Yb doped tungstate crystal, which has negative thermo-refractive coefficient. In order to stabilize the cavity mode, the gain crystal has a curved surface. That is, while gain crystals are often used to form diode pump lasers, these crystals typically are AR-coated flat-flat crystal with a separate concave HR mirror or a broadband concave output coupler (OC) to form a stable laser. However, forming a curved (e.g., convex) surface on the gain crystal enables stable operation of the laser without the need for a separate bulk optical component (e.g., a HR mirror or an OC). This advantageously simplifies assembly (e.g., makes alignment easier), make the laser system more resilient (e.g., to vibrations or shock during operation), and reduces cost.

In one embodiment, the laser system includes a volume holographic grating (VHG) (also referred to as a volume Bragg grating and is one type of a narrowband reflective OC) which, along with the curved surface of the gain crystal, allows for (or assists in) single longitudinal mode operation (e.g., where the laser lases at a desired frequency rather than having multiple frequencies). In addition, the gain crystal can be mounted on a transducer so its relative position to the diode pump laser can be adjusted, thereby changing the length of the laser cavity. The transducer allows power and wavelength tuning at the fundamental frequency of the laser.

In one embodiment, the laser system also includes a non-linear crystal in the laser cavity to frequency double the light emitted by the gain crystal during stimulated emission. The transducer can also provide power and wavelength tuning at the frequency doubled wavelength. Put differently, the transducer can move the gain crystal to provide power and wavelength tuning at the fundamental (e.g., 1064nm) and the frequency doubled (e.g., 532nm) wavelengths.

In one embodiment, a temperature control device (such as a thermoelectric cooler (TEC) or a heater) can be disposed in the laser system to control the temperature of the non-linear crystal and the VHG. The temperature control device, along with the transducer, can tune the wavelength and optimize the power at the desired wavelength. Moreover, the temperature control device can control the temperature of the non-linear crystal so it is within the range at which the non-linear crystal performs frequency doubling (since its operation is temperature dependent).

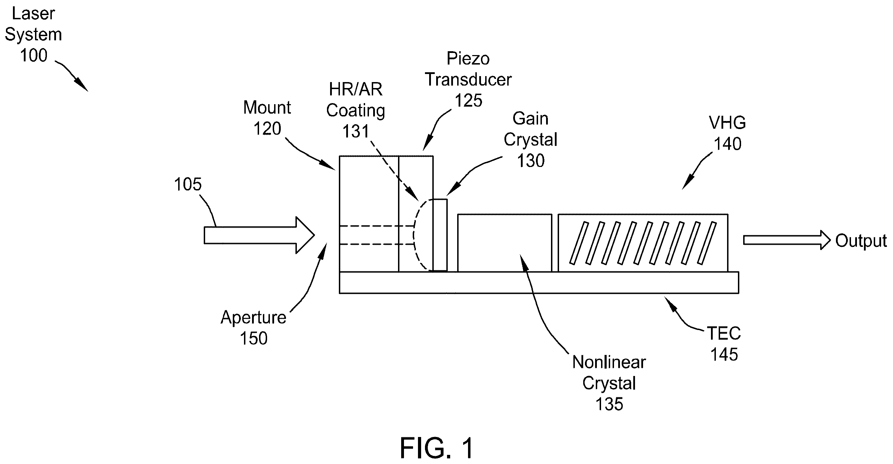

Figure 1 illustrates a laser system 100, according to one embodiment. In one embodiment, the input optical signal 105 is a 980nm optical pump generated by a diode pump laser, which has the advantage of being a commercially available optical source. The embodiments herein are not limited to any particular wavelength optical pump source, and indeed the type of the diode pump laser can change according to the application and design wavelength of the laser system 100. Moreover, the choice of the laser (as well as the desired output wavelength of the laser) can determine the types of the other material in the laser system 100 such as a gain crystal 130, nonlinear crystal 135, and VHG 140 as discussed in more detail below.

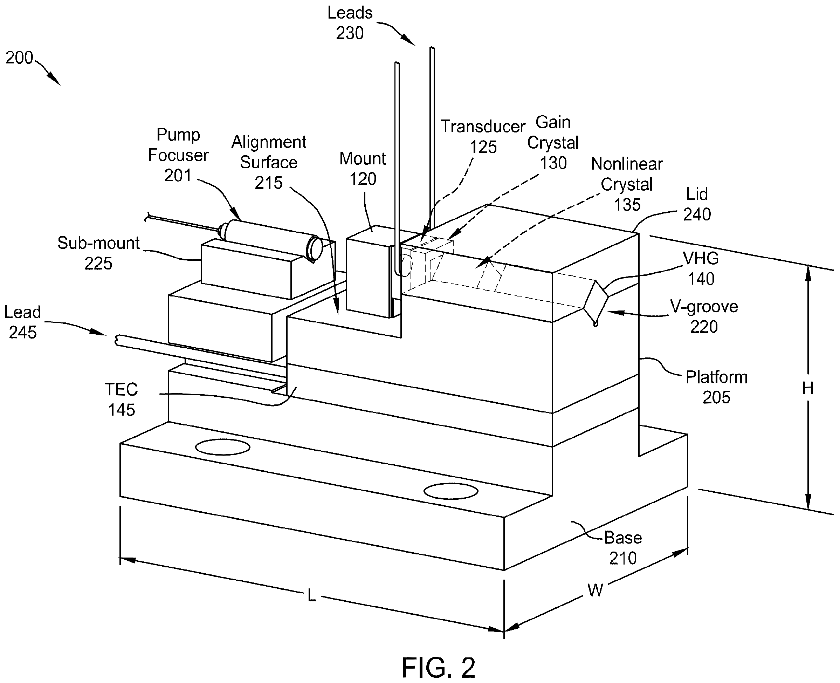

In one embodiment, the optical signal 105 generated by the laser is transmitted to a pump focuser using an optical fiber (which is shown in Figure 2). The pump focuser can be a free space optical component that focuses the spot size onto the gain crystal 130. However, in other embodiments the optical signal 105 could be directly received at the gain crystal 130 without the use of a pump focuser.

The gain crystal 130 is disposed on a piezo transducer 125 which can move the gain crystal 130 in the x direction (i.e., the left and right directions in Figure 1). This lateral movement provides power and wavelength tuning of the optical signals passing through the gain crystal 130. The piezo transducer 125 is in turn attached to a mount 120 which holds the transducer 125 in a fixed position relative to the optical source generating the optical signal 105. The mount 120 can be made of copper which has a low mechanical Q and reduces resonances. However, other materials can be used such as lead, lead filled copper, and Al-Fe alloy.

The mount 120 and the transducer 125 define respective apertures 150 that permit the optical signal 105 to reach the gain crystal 130 in free space. In the embodiment shown in Figure 1, the gain crystal 130 is at an end of the laser cavity. This advantageously suppresses longitudinal mode-hopping.

In one embodiment, the gain crystal 130 is ytterbium that is doped with potassium yttrium tungstate (Yb: KYW), however, this is just one example material. For example, if the optical signal 105 is 980nm light, an Yb: KYW gain crystal 130 performs stimulated emission by absorbing the 980nm light and fluoresces to emit light in the 1030-1070 nm band. In another example, the gain crystal 130 is an Yb gain medium that allows for pumping of optical signals with wavelengths in a 900 - 1000 nm pumping region. The VHG 140 is used to select a particular lasing wavelength, such as 1064 nm.

The 1064nm light is then frequency doubled to 532nm light by the nonlinear crystal 135. In this example, the 532nm is the desired wavelength of the laser. Thus, the gain crystal 130 generates optical power at a fundamental frequency (e.g., 1064nm) that can then be frequency doubled by the nonlinear crystal 135 to generate the desired output frequency (e.g., 532nm). As an example, 532nm may be the desired frequency for performing frequency modulation spectroscopy (FMS) or modulation transfer spectroscopy (MTS) with an Iodine vapor cell. However, for other types of vapor cells, a different output frequency may be needed, in which case the type of the laser, and the material of the gain crystal 130 and the nonlinear crystal 135 can be selected accordingly.

In some embodiments, the gain crystal 130 may output the desired wavelength without having to perform frequency doubling. In that case, in some embodiments, the laser system 100 may not include the nonlinear crystal 135. However, if the nonlinear crystal 135 is needed in order to achieve a laser with the desired wavelength, some example materials include potassium titanyl phosphate (KTP), LiNbO₃, periodically poled lithium niobate (PPLN), or periodically poled KTP (PPKTP).

The nonlinear crystal 135 is optically aligned with a VHG 140 which can be used to control the emission spectrum of high-power laser diodes. The VHG 140 is a frequency selective filter mirror that reflects one wavelength (e.g., 1064nm) but permits other wavelengths to pass through (e.g., the rest of the Yb gain emission at 1030-1070 nm or 532nm) to produce the output of the laser system 100. The VHG 140 is one type of narrowband reflective output coupler (OC). The VHG is narrowband relative to the emission spectrum of the gain crystal 130. The VHG selects a portion of the spectrum of the gain crystal 130. Other types of narrowband reflective OCs include an intra-cavity filter that only transmits narrowband, or a system that includes a diffraction grating and a mirror so only a narrow band is reflected back to the gain crystal 130.

The wavelength that is reflected by the VHG 140 (or other type of narrowband reflective OC) is the wavelength that the laser system 100 starts to lase at. In this example, the reflected 1064nm optical signal passes through the nonlinear crystal 135 and the gain crystal 130 until reaching a high reflective (HR)/anti-reflective (AR) coating 131 on the curved surface of the gain crystal 130. The HR/AR coating 131 can be designed so that it is highly reflective at 1064nm (so that the signals reflected by the VHG 140 are again reflected back towards the VHG 140) and anti-reflective at 980nm so the optical signal 105 can pass through the coating 131 and into the gain crystal as discussed above.

The HR/AR coating 131 on the convex surface of the gain crystal 130 eliminates the need for a separate HR/AR pump coupling mirror or broadband OC which makes the laser system 100 more robust, easier to assemble, and reduces cost. In addition, using a gain crystal 130 with a curved surface and the VHG 140 promotes single longitudinal mode operation. While the laser can operate in multiple discrete axial modes it is often desirable to operate in one mode. The curved surface of the crystal 130 and the VHG 140 ensures the laser system 100 lases at one frequency/wavelength rather than multiple different frequencies or wavelengths.

As discussed, using a polished curved (convex) gain crystal 130 stabilizes the laser without having to include a HR/AR pump coupling mirror or broadband OC. This technique can be applied to any gain crystal with a negative (or positive) thermal lens. That is, for some types of gain crystals, as they absorb light they heat up and turn into a convex lens because the center of the material absorbs more light/heat so that a flat surface turns into a curved, convex lens (i.e., has a positive thermal lens). While most types of gain crystals change into convex lens to create a stable cavity, Yb: KYW turns into a concave lens which makes the laser unstable (i.e., has a negative thermal lens). Here, the gain crystal 130 has a convex surface which remains convex during operation so that a HR/AR pump coupling mirror or broadband OC is not needed in order to compensate for the negative thermal lens behavior of Yb: KYW. In contrast, for gain media with positive thermo-refractive coefficient, it is usually sufficient to have a flat gain crystal as the cavity end mirror. The heating due to the pump absorption turns these flat surface into a convex surface during operation, stabilizing the cavity mode.

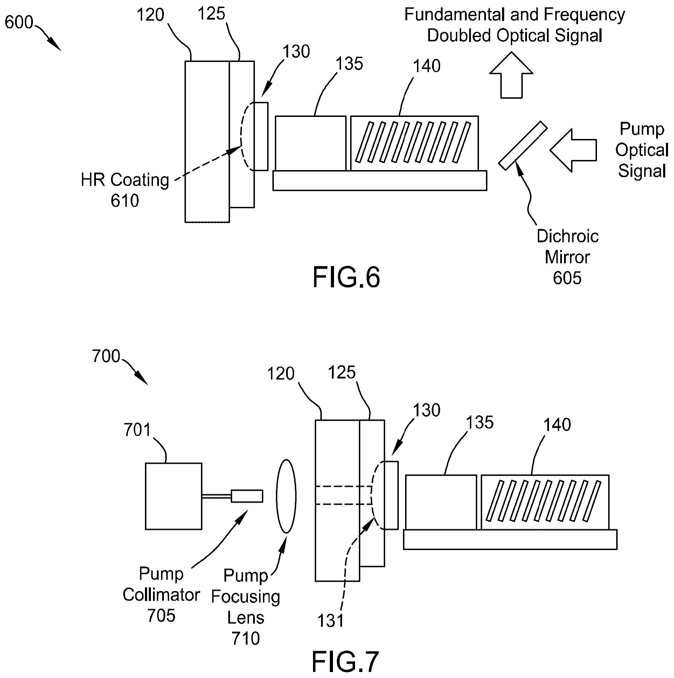

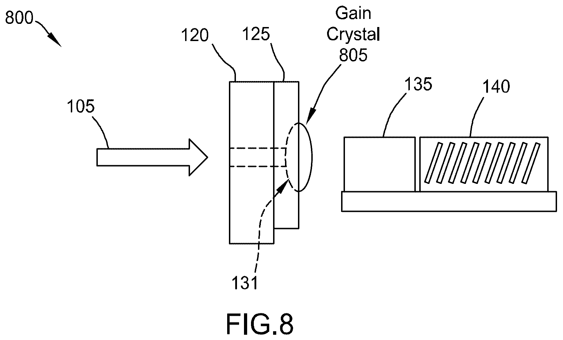

While the curved, convex surface of the gain crystal 130 is facing the optical signal 105, in other embodiments the flat surface of the gain crystal 130 may face the optical signal 105. Such an embodiment is also illustrated in Figure 6 below. Moreover, while the gain crystal 130 can have one side with a curved side and an opposite side with a flat surface, in other embodiments the gain crystal may have two curved surfaces (e.g., have a circular or oval shape). This is illustrated in Figure 8 below.

The nonlinear crystal 135, the VHG 140, and the mount 120 are disposed on (or are at least thermally coupled to) a TEC 145. The TEC 145 is one example of a temperature control device that can change the temperature of these two components. In other embodiments, a heater could be used to control the temperature of the nonlinear crystal 135, the VHG 140, and the mount 120. The lateral adjustments made by the transducer 125 and the temperature control of the TEC 145 allows for fast optimization of frequency doubled power and wavelength of the fundamental optical signal (e.g., 1064nm) and the frequency doubled optical signal (e.g., 532nm). These components, plus the narrow bandwidth of the VHG 140, allows single longitudinal mode operation at optimal laser power with a tunable wavelength (e.g., the fundamental and frequency doubled wavelengths) over a temperature range of the non-linear crystal 135. That is, the operation of the nonlinear crystal 135 and the VHG 140 can depend on temperature. As such, the materials of these components can be selected so they perform the desired functions at generally the same temperature range so that a single temperature control device (e.g., the TEC 145) can be used to control the temperature of both components.

Moreover, although not labeled in Figure 1, the flat surface of the gain crystal 130 and the input and output surfaces of the nonlinear crystal 135 and the VHG 140 can have AR coatings. These coatings can be for the fundamental and the second harmonic of the optical signal.

Figure 2 illustrates a perspective view of a laser system 200, according to one embodiment. Figure 2 includes many of the same components as described in Figure 1, as indicated by using the same reference numbers. Those components will not be described in detail here.

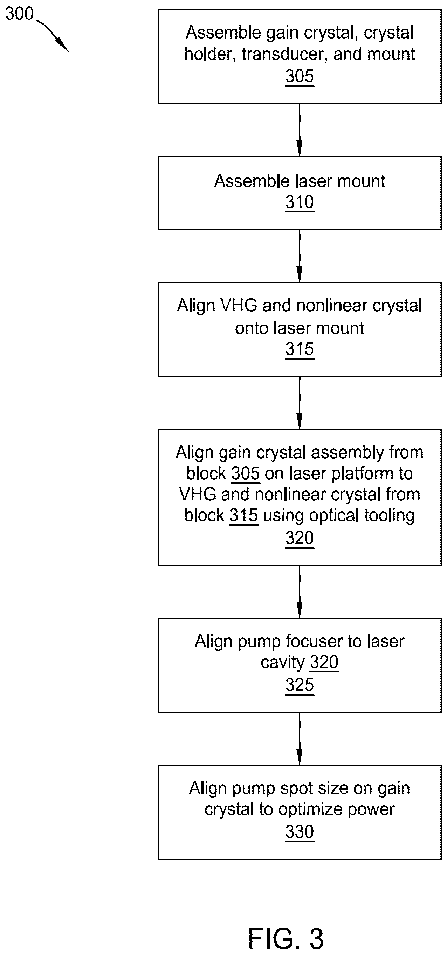

The laser system 200 includes a base 210 that supports the TEC 145 and a pump focuser sub-mount 225. In addition, a platform 205 (e.g., an Aluminum Nitride (AIN) platform) disposed on the TEC 145 includes a v-groove 220 used to optically align the nonlinear crystal 135 and the VHG 140 to each other. Further, the platform 205 includes an alignment surface 215 on which the mount 120 for the transducer 125 and the gain crystal 130 rests. The height difference between the alignment surface 215 and the v-groove 220 can be set when fabricating the TEC 145 so that when the mount 120 rests on the alignment surface 215, the gain crystal 130 is aligned (at least in the vertical direction) with the nonlinear crystal 135 and the VHG 140 in the v-groove 220. This enables passive alignment in the vertical direction. The details of assembling and aligning the laser systems 100 and 200 are discussed in more detail in Figure 3 below.

The laser system 200 includes a sub-mount 225 with a v-groove for aligning a pump focuser 201 to the gain crystal 130 (and the other optical components forming the laser cavity). That is, the v-groove in the sub-mount 225 may be at (or near) the same height as the v-groove 220 so that the optical signal emitted by the pump focuser can pass through the gain crystal 130, the nonlinear crystal 135, and the VHG 140 as discussed above.

In this embodiment, the sub-mount 225 and the platform 205/TEC 145 are disposed on a base 210 (e.g., a laser base or a mounting base plate). The material of the sub-mount 225 and the platform 205 can be any suitable material (e.g., a rigid and thermally conductive material).

Figure 2 also illustrates leads 230 that can be used to control the transducer 125 which can move the gain crystal 130 along the optical path. As discussed above, this movement can be used to provide power and wavelength tuning at the fundamental frequency and the doubled frequency of the laser system 200. Figure 2 also illustrates a lead 245 extending to the TEC 145 for powering (and controlling) the TEC 145. For example, the lead 245 (as well as another lead not shown) can supply voltage and current to the TEC 145 to control the temperature of the thermally coupled components in the laser system 200.

Figure 2 illustrates the length (L), width (W), and height (H) dimensions of the laser system 200. In this example, the L and W of the base 210 define the L and W of the laser system 200. The L can range from 40-60mm while the W can range from 25-40mm. The H is measured from the bottom of the base 210 to the top of a lid 240 that is attached to the top surface of the platform 205. The H can range from 20-40mm.

Figure 3 is a flowchart of a method 300 for assembling a laser system, according to one embodiment. The method 300 can be used to assemble the laser systems illustrate in Figures 2 and 3.

At block 305, a gain crystal is fixed to a mount and the gain crystal/mount subassembly is attached to a transducer. In one embodiment, the crystal/mount/transducer assembly is then fixed to mount 120 in Figure 2. In one embodiment, the gain crystal includes a curved surface, such as a convex surface. Moreover, the gain crystal can be made of a material with a negative thermal lens, but in other embodiments may have a positive thermal lens.

In one embodiment, a HR/AR coating is applied to the gain crystal. The coating can be anti-reflective at the frequency of the diode pump laser but highly reflective at the wavelength of the light emitted by the gain crystal through stimulated emission and at the frequency doubled wavelength generated by the nonlinear crystal. For example, the pump laser may generate light at 980nm which is able to pass through the HR/AR coating. The gain crystal can emit light at 1064nm when performing stimulated emission. As this light may be reflected back towards the gain crystal (e.g., by a VHG), the HR/AR coating reflects this light to keep the 1064nm and frequency doubled 532nm light from being emitted towards the pump laser.

At block 310, the laser mount is assembled. Using Figure 2 as an example, the laser mount can include attaching the TEC 145 to the base 210 and then attaching the platform 205 to the TEC 145. The platform 205 can be fabricated by the manufacture to include the alignment surface 215 and the v-groove 220.

At block 315, the nonlinear crystal and the VHG are aligned onto the laser mount. In the example shown in Figure 2, the nonlinear crystal 135 and the VHG 140 are placed in the v-groove 220 which passively aligns these components. While a square shape is shown, the nonlinear crystal 135 and the VHG 140 can have other shapes, such as a cylinder, and still be aligned using the v-groove 220.

At block 320, the gain crystal assembly is aligned to the VHG and nonlinear crystal attached to the laser mount. In one embodiment, a gain crystal assembly formed at block 305 is aligned to the nonlinear crystal and the VHG disposed on the laser mount. As discussed in block 305, the gain crystal can be mounted onto the transducers which is in turn disposed on a mount. This assembly can be disposed on an alignment surface (e.g., the alignment surface 215 of the platform 205 in Figure 2) so the gain crystal is at a same height as the nonlinear crystal and the VHG. Mechanical and optical tooling can be used to align the gain crystal to the nonlinear crystal and the VHG.

At block 325, the pump is aligned to the laser cavity. In Figure 2, this can include placing the pump focuser 201 in the v-groove of the sub-mount 225. As shown in Figure 2, the sub-mount 225 is mounted on the base 210, like the other components in the laser system 200.

At this stage, the lasing of the system can be verified by transmitting the pump optical signal through the pump focuser and into the gain crystal, the nonlinear crystal, and the VHG. Further alignment can be performed by measuring the resulting output.

At block 330, the spot size at the gain crystal is adjusted to optimize laser power. In one embodiment, adjusting the spot size includes sliding the pump focuser in the v-groove of the sub-mount, thereby changing the separation distance between the pump focuser and the gain crystal.

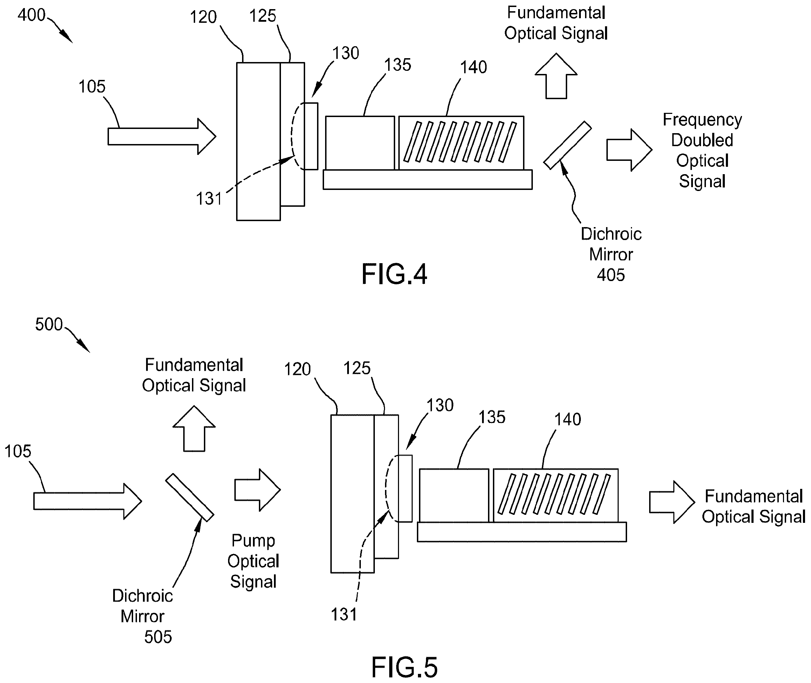

Figures 4-8 illustrates various implementations of a laser system with a diode pump laser, according to several embodiments. Figures 4-8 include many of the same components as described in Figure 1, as indicated by using the same reference numbers. Those components will not be described in detail here.

Figure 4 illustrates a laser system that includes a dichroic mirror 405 disposed at the output of the VHG 140. The dichroic mirror 405 is a filter that uses, for example, alternating layers of dielectric films with particular thicknesses to obtain reflection and transmission at chosen frequency bands. In this example, the dichroic mirror 405 reflects the fundamental optical signal (i.e., the optical signal emitted by the gain crystal as part of stimulated emission) but permits the frequency doubled optical signal (which was doubled by the nonlinear crystal 135) to pass through. The frequency doubled optical signal can also be referred to as the second harmonic optical signal.

By separating the fundamental optical signal from the frequency doubled optical signal at the output of the VHG 140, the fundamental optical signal can be used for additional laser stabilization tasks. For example, the fundamental optical signal can be used to stabilize the laser to a high-finesse cavity to reduce linewidth and get better precision for spectroscopy performed at the wavelength of the frequency doubled optical signal (e.g., 532nm). In another example, for clock applications, it is often easier to stabilize a frequency comb to the laser using the fundamental optical signal than the frequency doubled optical signal.

Figure 5 also illustrates a laser system 500 with a dichroic mirror 505. However, in this example the dichroic mirror 505 is disposed between the received optical signal 105 and the gain crystal 130. Here, the dichroic mirror 505 reflects the fundamental optical signal (i.e., the optical signal emitted by the gain crystal as part of stimulated emission) but permits the pump optical signal 105 to pass through. This offers the same advantage of Figure 4 where the fundamental optical signal can be used for additional laser stabilization tasks.

The AR/HR coating 131 is AR at the pump wavelength and HR at the fundamental and frequency doubled wavelengths. Moreover, in one embodiment, the HR coating of the AR/HR coating 131 may be less reflective than coating 131 in Figure 4. As a result, a small amount of light at the fundamental wavelength (e.g., 1%) is transmitted through the back side where the dichroic mirror 505 is used to separate it from the incoming pump beam.

Figure 6 illustrates pumping a laser system 600 at the opposite end of the gain crystal 130. That is, instead of disposing the pump laser on the same side as the gain crystal, the pump optical signal is instead transmitted to the VHG 140 via a dichroic mirror 605. The dichroic mirror 605 permits the pump optical signal (e.g., 980nm) to pass through to reach the VHG 140. This optical signal passes through the VHG 140 and the nonlinear crystal 135 until reaching the gain crystal 130. Notably, the nonlinear crystal 135 may be frequency selective such that it does not affect the pump optical signal (i.e., the crystal 135 does not frequency double the pump optical signal).

Like above, the gain crystal 130 uses stimulated emission to emit light at a desired frequency (e.g., the fundamental optical signal). The gain crystal 130 can include an HR coating 610 that reflects light at all frequencies. That way, the pump signal is double passed through the gain crystal and the fundamental optical signal is directed towards the nonlinear crystal 135 which now performs frequency doubling on the fundamental optical signal. This frequency doubled optical signal (i.e., the output of the laser) is then reflected upwards collinearly with the fundamental signal by the dichroic mirror 605.

Figure 7 illustrates a laser system 700 that is similar to the laser system 100 in Figure 1 except that the pump focuser illustrated in Figure 2 has been replaced by a pump collimator 705 and a pump focusing lens 710 that receive an optical signal generated by a laser source 701 (e.g., a diode pump laser). However, this may be harder to align than the laser system 100. Nonetheless, the laser system 700 functions the same as the laser system 100.

Figure 8 illustrates a laser system 800 that is similar to the laser system 100 in Figure 1 except that the gain crystal 805 has two curved (convex) surfaces instead of one. While the advantages described above are still achieved by using the gain crystal 805, the gain crystal 805 may be more costly and complex to manufacture.

The preceding description is provided to enable any person skilled in the art to practice the various embodiments described herein. The examples discussed herein are not limiting of the scope, applicability, or embodiments set forth in the claims. Various modifications to these embodiments will be readily apparent to those skilled in the art, and the generic principles defined herein may be applied to other embodiments. For example, changes may be made in the function and arrangement of elements discussed without departing from the scope of the disclosure. Various examples may omit, substitute, or add various procedures or components as appropriate. For instance, the methods described may be performed in an order different from that described, and various steps may be added, omitted, or combined. Also, features described with respect to some examples may be combined in some other examples. For example, an apparatus may be implemented or a method may be practiced using any number of the aspects set forth herein. In addition, the scope of the disclosure is intended to cover such an apparatus or method that is practiced using other structure, functionality, or structure and functionality in addition to, or other than, the various aspects of the disclosure set forth herein. It should be understood that any aspect of the disclosure disclosed herein may be embodied by one or more elements of a claim.

As used herein, the word "exemplary" means "serving as an example, instance, or illustration." Any aspect described herein as "exemplary" is not necessarily to be construed as preferred or advantageous over other aspects.

As used herein, a phrase referring to "at least one of" a list of items refers to any combination of those items, including single members. As an example, "at least one of: a, b, or c" is intended to cover a, b, c, a-b, a-c, b-c, and a-b-c, as well as any combination with multiples of the same element (e.g., a-a, a-a-a, a-a-b, a-a-c, a-b-b, a-c-c, b-b, b-b-b, b-b-c, c-c, and c-c-c or any other ordering of a, b, and c).

As used herein, the term "determining" encompasses a wide variety of actions. For example, "determining" may include calculating, computing, processing, deriving, investigating, looking up (e.g., looking up in a table, a database or another data structure), ascertaining and the like. Also, "determining" may include receiving (e.g., receiving information), accessing (e.g., accessing data in a memory) and the like. Also, "determining" may include resolving, selecting, choosing, establishing and the like.

The methods disclosed herein comprise one or more steps or actions for achieving the methods. The method steps and/or actions may be interchanged with one another without departing from the scope of the claims. In other words, unless a specific order of steps or actions is specified, the order and/or use of specific steps and/or actions may be modified without departing from the scope of the claims. Further, the various operations of methods described above may be performed by any suitable means capable of performing the corresponding functions. The means may include various hardware and/or software component(s) and/or module(s), including, but not limited to a circuit, an application specific integrated circuit (ASIC), or processor. Generally, where there are operations illustrated in figures, those operations may have corresponding counterpart means-plus-function components with similar numbering.

The following claims are not intended to be limited to the embodiments shown herein, but are to be accorded the full scope consistent with the language of the claims. Within a claim, reference to an element in the singular is not intended to mean "one and only one" unless specifically so stated, but rather "one or more." Unless specifically stated otherwise, the term "some" refers to one or more. No claim element is to be construed under the provisions of 35 U.S.C. §112(f) unless the element is expressly recited using the phrase "means for" or, in the case of a method claim, the element is recited using the phrase "step for." All structural and functional equivalents to the elements of the various aspects described throughout this disclosure that are known or later come to be known to those of ordinary skill in the art are expressly incorporated herein by reference and are intended to be encompassed by the claims. Moreover, nothing disclosed herein is intended to be dedicated to the public regardless of whether such disclosure is explicitly recited in the claims.

### FURTHER EMBODIMENTS

1. A laser system, comprising:
   a pump laser configured to output a pump optical signal;
   a gain crystal comprising a curved surface to serve as one end mirror of a laser cavity, wherein the gain crystal is configured to perform stimulated emission upon receiving the pump optical signal; and
   a narrowband reflective output coupler (OC) for the pump optical signal.
2. The laser system of embodiment 1, wherein the curved surface is a convex surface, wherein the curved surface comprises at least one of a high reflective (HR) surface that reflects a fundamental optical signal produced by the gain crystal through stimulated emission.
3. The laser system of embodiment 2, wherein the curved surface comprises an HR and an anti-reflective (AR) coating that reflects the fundamental optical signal produced by the gain crystal and permits the pump optical signal to pass through the gain crystal.
4. The laser system of embodiment 1, wherein the narrowband reflective OC comprises a volume holographic grating (VHG) optically aligned with the gain crystal to assist in single longitudinal mode operation of the laser system.
5. The laser system of embodiment 4, further comprising:
   a nonlinear crystal configured to frequency double a fundamental optical signal produced by the gain crystal through stimulated emission, wherein the nonlinear crystal is disposed between the gain crystal and the VHG.
6. The laser system of embodiment 5, further comprising:
   a temperature control device, wherein the nonlinear crystal and the VHG are disposed on the temperature control device so that the temperature control device can control a temperature of the nonlinear crystal and the VHG.
7. The laser system of embodiment 6, wherein the nonlinear crystal and the VHG are disposed in a v-groove in the temperature control device.
8. The laser system of embodiment 7, further comprising:
   a mount, wherein the gain crystal is supported by the mount,
   wherein the mount is disposed on alignment surface of the temperature control device so that the gain crystal is at a same height as the nonlinear crystal and the VHG.
9. The laser system of embodiment 4, further comprising:
   a dichroic mirror disposed one of:
   at an output of the VHG, or
   between the pump laser and the gain crystal.
10. The laser system of embodiment 1, further comprising:
   a transducer, wherein the gain crystal is mounted on the transducer so that the gain crystal can be moved to adjust a length of a laser cavity of the laser system.
11. The laser system of embodiment 10, wherein the transducer defines an aperture through which the pump optical signal can propagate to reach the gain crystal.
12. The laser system of embodiment 11, further comprising:
   a mount, wherein the transducer is mounted on the mount, wherein the mount defines an aperture aligned with the aperture defined by the transducer; and
   a pump focuser configured to receive the pump optical signal from the pump laser and focus a spot size on the gain crystal.
13. The laser system of embodiment 1, wherein the gain crystal comprises a flat surface opposite the curved surface, wherein an AR coating is disposed on the flat surface.
14. The laser system of embodiment 1, wherein a material of the gain crystal has a negative or positive thermal lens.
15. The laser system of embodiment 14, wherein the material of the gain crystal comprises an ytterbium gain medium that allows for pumping in a 900-1000 nm wavelength pumping region.
16. A laser system, comprising:
   a pump focuser configured to output a pump optical signal;
   a gain crystal comprising a curved surface, wherein the gain crystal is configured to perform stimulated emission upon receiving the pump optical signal; and
   a narrowband reflective output coupler (OC) for the pump optical signal.
17. The laser system of embodiment 16, wherein the curved surface is a convex surface, wherein the curved surface comprises at least one of a high reflective (HR) surface that reflects a fundamental optical signal produced by the gain crystal through stimulated emission.
18. The laser system of embodiment 17, wherein the curved surface comprises an HR and AR coating that reflects the fundamental optical signal produced by the gain crystal and permits the pump optical signal to pass through the gain crystal.
19. A method of assembling a laser system, the method comprising:
   aligning a gain crystal with a curved surface to a narrowband reflective output coupler (OC); and
   aligning, after aligning the gain crystal to the narrowband reflective OC, a pump laser to the gain crystal and the narrowband reflective OC.
20. The method of embodiment 19, further comprising:
   attaching the gain crystal to a transducer so that the gain crystal can be moved to adjust a length of a laser cavity of the laser system.

## Claims

1. A laser system, comprising:
a pump laser configured to output a pump optical signal;
a gain crystal comprising a curved surface to serve as one end mirror of a laser cavity, wherein the gain crystal is configured to perform stimulated emission upon receiving the pump optical signal; and
a narrowband reflective output coupler (OC) for the pump optical signal.

2. The laser system of claim 1, wherein the curved surface is a convex surface, wherein the curved surface comprises at least one of a high reflective (HR) surface that reflects a fundamental optical signal produced by the gain crystal through stimulated emission.

3. The laser system of claim 2, wherein the curved surface comprises an HR and an anti-reflective (AR) coating that reflects the fundamental optical signal produced by the gain crystal and permits the pump optical signal to pass through the gain crystal.

4. The laser system of claim 1, wherein the narrowband reflective OC comprises a volume holographic grating (VHG) optically aligned with the gain crystal to assist in single longitudinal mode operation of the laser system.

5. The laser system of claim 4, further comprising:
a nonlinear crystal configured to frequency double a fundamental optical signal produced by the gain crystal through stimulated emission, wherein the nonlinear crystal is disposed between the gain crystal and the VHG.

6. The laser system of claim 5, further comprising:
a temperature control device, wherein the nonlinear crystal and the VHG are disposed on the temperature control device so that the temperature control device can control a temperature of the nonlinear crystal and the VHG.

7. The laser system of claim 6, wherein the nonlinear crystal and the VHG are disposed in a v-groove in the temperature control device.

8. The laser system of claim 7, further comprising:
a mount, wherein the gain crystal is supported by the mount,
wherein the mount is disposed on alignment surface of the temperature control device so that the gain crystal is at a same height as the nonlinear crystal and the VHG.

9. The laser system of claim 4, further comprising:
a dichroic mirror disposed one of:
at an output of the VHG, or
between the pump laser and the gain crystal.

10. The laser system of claim 1, further comprising:
a transducer, wherein the gain crystal is mounted on the transducer so that the gain crystal can be moved to adjust a length of a laser cavity of the laser system.

11. The laser system of claim 10, wherein the transducer defines an aperture through which the pump optical signal can propagate to reach the gain crystal.

12. The laser system of claim 11, further comprising:
a mount, wherein the transducer is mounted on the mount, wherein the mount defines an aperture aligned with the aperture defined by the transducer; and
a pump focuser configured to receive the pump optical signal from the pump laser and focus a spot size on the gain crystal.

13. The laser system of claim 1, wherein the gain crystal comprises a flat surface opposite the curved surface, wherein an AR coating is disposed on the flat surface; or
wherein a material of the gain crystal has a negative or positive thermal lens, especially wherein the material of the gain crystal comprises an ytterbium gain medium that allows for pumping in a 900-1000 nm wavelength pumping region.

14. A method of assembling a laser system, the method comprising:
aligning a gain crystal with a curved surface to a narrowband reflective output coupler (OC); and
aligning, after aligning the gain crystal to the narrowband reflective OC, a pump laser to the gain crystal and the narrowband reflective OC.

15. The method of claim 14, further comprising:
attaching the gain crystal to a transducer so that the gain crystal can be moved to adjust a length of a laser cavity of the laser system.
